# FASCICULE DE BREVET EUROPEEN

(11) **EP 4 073 527 B1**
(45) Date de publication et mention de la délivrance du brevet: **07.02.2024**
(21) Numéro de dépôt: 20816523.3
(22) Date de dépôt: 07.12.2020
(51) Int. Cl.: G01R 31/382, G01R 31/392

(54) **PROCÉDÉ DE DÉTERMINATION D'UN SIGNAL SONDE, PROCÉDÉ DE VÉRIFICATION ET DE DÉTECTION D'UN DÉFAUT DANS UN SYSTÈME ÉLECTROCHIMIQUE FAISANT USAGE D'UN TEL SIGNAL**
VERFAHREN ZUR BESTIMMUNG EINES PRÜFSIGNALS, VERFAHREN ZUR ÜBERPRÜFUNG UND ERKENNUNG EINES FEHLERS IN EINEM ELEKTROCHEMISCHEN SYSTEM MIT EINEM SOLCHEN SIGNAL
METHOD FOR DETERMINING A TEST SIGNAL, METHOD FOR CHECKING FOR AND DETECTING A FAULT IN AN ELECTROCHEMICAL SYSTEM EMPLOYING SUCH A SIGNAL

(30) Priorité: 09.12.2019 FR 1913931
(43) Date de publication de la demande: 19.10.2022
(73) Titulaire: Commissariat à l'Energie Atomique et aux Energies Alternatives, 75015 Paris (FR)
(72) Inventeur: GUILLET, Nicolas, 38054 GRENOBLE CEDEX 09 (FR); GAU, Vincent, 38054 GRENOBLE CEDEX 09 (FR)
(74) Mandataire: Cabinet Camus Lebkiri
(86) Numéro de dépôt international: PCT/EP2020/084816
(87) Numéro de publication internationale: WO 2021/115992

(56) Documents cités:
- EP-A1- 2 575 205
- DE-A1-102015 210 266
- US-A1- 2019 049 518

## Description

### DOMAINE TECHNIQUE DE L'INVENTION

Le domaine technique de l'invention est celui du diagnostic non intrusif et en fonctionnement des systèmes électrochimiques de conversion de l'énergie (piles, batteries, piles à combustible, etc.).

La présente invention concerne la détermination d'un signal sonde et l'utilisation de ce signal dans le suivi et la détection de défauts d'un système électrochimique. La présente invention concerne également un dispositif configuré pour mettre en oeuvre une telle détection.

### ARRIERE-PLAN TECHNOLOGIQUE DE L'INVENTION

Les systèmes de surveillance et de gestion de batterie sont indispensables afin de satisfaire de la manière la plus efficace possible aux demandes des utilisateurs. De manière générale, les systèmes de surveillance et de gestion prennent en compte l'état de charge de la batterie, l'état de santé de la batterie et/ou l'état de sécurité de la batterie (détection d'un fonctionnement anormal). Ces différentes informations sont généralement obtenues par la mesure de grandeurs électriques aux bornes de la batterie, mais également par des données externes telles que celles fournies par les techniques d'analyse thermique (mesure de température et/ou de flux de chaleur) ou de contrôle non destructif (caractérisation acoustique par exemple). A partir des informations obtenues par les mesures, le système de gestion régule le fonctionnement de la batterie pour en optimiser les performances et garantir la sécurité de l'ensemble.

Les techniques de surveillance des batteries en fonctionnement par signaux acoustiques ultrasonore actuellement proposées (Gold et al., 2017; Sood, Pecht, & Osterman, 2016; Steingart et al., 2016, DE102015210266A1) présentent cependant certains inconvénients. Tout d'abord, elles ne s'intéressent qu'à certains indicateurs de fonctionnement de la batterie indépendamment les uns des autres (état de charge, état de santé température, détection de défauts) et ne prennent pas en considération l'ensemble des informations contenues dans le signal acoustique mesuré.

D'autres documents pertinents pour l'état de la technique sont US 2019/049518 A1 et EP 2 575 205 A1.

Ensuite, les paramètres spécifiques des signaux acoustiques incidents utilisés sont souvent choisis de manière plus ou moins arbitraire et ne prennent pas en compte les particularités de chaque batterie. Il en résulte une perte d'informations pertinentes pour la gestion optimale des batteries et ne permettent pas non plus de tenir compte de l'évolution des caractéristiques de la batterie au cours de sa vie.

Enfin, la plupart des travaux utilisent des signaux incidents sous la forme de pulses de courte durée (de quelques dizaines de ns à quelques ms) qui ne permettent pas l'établissement d'un régime stationnaire au sein de la batterie, limitant ainsi la capacité des outils mathématiques utilisés pour l'analyse des signaux.

Le choix de la fréquence du signal incident est très important. Il dépend beaucoup du montage expérimental utilisé (propriétés des transducteurs utilisés pour l'émission du signal incident et la réception du signal transmis, particularités géométriques de la batterie testée, nature des matériaux qui la composent etc...) des informations attendues (mesure de temps de vol, analyse fréquentielle ou temporelle du signal transmis) et des propriétés structurelles des matériaux dont on veut suivre l'évolution (fines couches d'électrodes, matériaux denses ou poreux etc...).

Il existe donc un besoin d'une méthode efficace permettant de déterminer les paramètres optimaux du signal acoustique incident (fréquence, durée, amplitude) pour détecter les variations et évolutions du signal transmis avec la plus grande précision.

### RESUME DE L'INVENTION

L'invention offre une solution aux problèmes évoqués précédemment, en permettant de déterminer les caractéristiques d'un signal sonde spécifique au système électrochimique sondé acoustiquement. De plus, l'adaptabilité du signal sonde permet de prendre en compte différentes conditions de fonctionnement et de tenir compte de l'évolution du système électrochimique au cours de sa vie ainsi que la détection d'une éventuelle anomalie dans le fonctionnement du système électrochimique.

Pour cela, un premier aspect de l'invention concerne un procédé de détermination d'un signal sonde pour l'interrogation acoustique d'un système électrochimique, ledit procédé étant caractérisé en ce qu'il comprend :
- une étape d'émission d'un premier signal, dit signal de calibration, comprenant un train d'onde de multiples fréquences, la densité spectrale associée à chaque fréquence étant identique ;
- une étape de réception de la réponse du système électrochimique au signal de calibration ;
- une étape de détermination, à partir de la réponse réceptionnée et pour chaque fréquence du signal de calibration, d'un facteur d'atténuation du signal ;
- une étape de détermination, pour chaque facteur d'atténuation, d'un facteur correctif fonction dudit facteur d'atténuation de sorte à associer un facteur correctif à chaque fréquence du signal de calibration ;
- une étape de détermination du signal sonde, ledit signal sonde étant obtenu en multipliant la densité spectrale associée à chaque fréquence du signal de calibration par le facteur correctif correspondant à la fréquence considérée.

Grâce à l'invention, le signal sonde déterminé prend en considération les spécificités du système électrochimique à interroger. De plus, la réponse du système au signal sonde comporte une densité spectrale caractéristique dont il devient facile d'observer les changements, ce qui améliore grandement la détection du vieillissement du système électrochimique ou d'éventuels défauts de ce dernier.

Outre les caractéristiques qui viennent d'être évoquées dans le paragraphe précédent, le procédé selon un premier aspect de l'invention peut présenter une ou plusieurs caractéristiques complémentaires parmi les suivantes, considérées individuellement ou selon toutes les combinaisons techniquement possibles.

Avantageusement, la densité spectrale (et donc l'amplitude) associée à chaque fréquence dans le signal de calibration est choisie de sorte à induire une réponse linéaire du système électrochimique.

Avantageusement, la durée du signal de calibration est suffisamment longue pour établir un régime stationnaire dans la réponse du système électrochimique.

Avantageusement, les fréquences associées à un facteur d'une atténuation supérieure à un seuil prédéterminé ne sont pas prises en compte pour la détermination du signal sonde.

Avantageusement, lors de l'étape d'émission d'un premier signal, le signal de calibration est émis alors que le système électrochimique se trouve dans un état de référence.

Un deuxième aspect de l'invention concerne un procédé de vérification de la conformité d'un système électrochimique à vérifier par rapport à un système électrochimique de référence caractérisé en ce qu'il comprend :
- une étape de détermination d'un signal sonde à l'aide d'un procédé selon un premier aspect de l'invention mis en oeuvre sur un système électrochimique de référence ;
pour chaque système électrochimique d'étalonnage d'une pluralité de systèmes électrochimiques d'étalonnage :
- une étape d'émission du signal sonde précédemment déterminé ;
- une étape de réception de la réponse du système électrochimique d'étalonnage audit signal sonde ;
une statistique des réponses des systèmes d'étalonnage étant ainsi obtenue ; le procédé comprenant également :
- une étape d'émission du signal sonde dans un système électrochimique à vérifier ;
- une étape de réception de la réponse du système électrochimique à vérifier audit signal sonde ;
- une étape de comparaison de la réponse du système électrochimique à vérifier à la statistique des réponses des systèmes électrochimique d'étalonnage de sorte à détecter un défaut du système électrochimique à vérifier.

Un troisième aspect de l'invention concerne un procédé de détection d'un défaut d'un système électrochimique, ledit procédé étant caractérisé en ce qu'il comprend :
- une étape de détermination d'un signal sonde à l'aide d'un procédé selon un premier aspect de l'invention ;
- une étape d'émission du signal sonde précédemment déterminé ;
- une étape de réception de la réponse du système électrochimique audit signal sonde;
- une étape d'analyse de la réponse de sorte à détecter un défaut du système électrochimique.

De préférence, les étapes d'émission d'un signal sonde, de réception de la réponse du système électrochimique et d'analyse de la réponse sont répétées à intervalles de temps réguliers ou à intervalles de temps variables.

Outre les caractéristiques qui viennent d'être évoquées dans le paragraphe précédent, le procédé selon un troisième aspect de l'invention peut présenter une ou plusieurs caractéristiques complémentaires parmi les suivantes, considérées individuellement ou selon toutes les combinaisons techniquement possibles.

Avantageusement, lors de l'étape de détermination d'un signal sonde, le signal sonde est déterminé alors que le système électrochimique est dans un état de référence.

Avantageusement, les étapes d'émission d'un signal sonde, de réception de la réponse du système électrochimique et d'analyse de la réponse sont mises en oeuvre à chaque fois que le système électrochimique est dans l'état de référence utilisé pour déterminer le signal sonde lors de l'étape de détermination d'un signal sonde.

Avantageusement, l'étape d'analyse de la réponse comprend :
- une sous-étape de détermination de la densité spectrale de la réponse au signal sonde ;
- une sous-étape de mémorisation de la densité spectrale de la réponse au signal sonde ;
- une sous-étape de comparaison de la densité spectrale déterminée à une statistique des réponses, ladite statistique des réponses étant déterminée à partir des densités spectrales mémorisées lors des mises en oeuvre précédentes de l'étape de mémorisation de la densité spectrale de la réponse au signal sonde ;
- une sous-étape de détection d'un défaut du système électrochimique lorsque l'écart entre la densité spectrale déterminée lors de la sous-étape de détermination et la statistique des réponses est supérieur à une valeur prédéterminée.

Avantageusement, le signal sonde est déterminé à nouveau à intervalle régulier ou sur demande d'un utilisateur

Avantageusement, lorsque la vitesse de la variation de la réponse s'écarte au-delà d'un seuil prédéfini, un dysfonctionnement du système électrochimique est détecté lors de l'étape d'analyse de la réponse. La vitesse de variation de la réponse est définie comme la différence entre les deux dernières réponses mesurées divisée par le temps séparant ces deux mesures.

Avantageusement, le procédé selon un troisième aspect de l'invention comprend, lorsqu'un défaut est détecté, une étape d"envoi d'un signal au système de gestion en charge du système électrochimique.

Avantageusement, le procédé selon un troisième aspect de l'invention comprend, après l'étape d'analyse de la réponse de sorte à détecter un défaut du système électrochimique :
- une étape de détermination d'un nouveau signal sonde à l'aide d'un procédé selon un premier aspect de l'invention, les facteurs de correction étant mémorisés ;
- une étape d'analyse de l'évolution des facteurs correctifs de sorte à détecter un éventuel défaut.

Un quatrième aspect de l'invention concerne un dispositif comprenant les moyens configurés pour mettre en oeuvre un procédé selon un premier, un deuxième ou un troisième aspect de l'invention.

Un cinquième aspect de l'invention concerne un programme d'ordinateur comprenant des instructions qui, lorsque le programme est exécuté par un ordinateur, conduisent celui-ci à mettre en oeuvre le procédé selon le premier, le deuxième ou le troisième aspect de l'invention.

Un sixième aspect de l'invention concerne un support de données lisible par ordinateur, sur lequel est enregistré le programme d'ordinateur selon un cinquième aspect de l'invention.

L'invention et ses différentes applications seront mieux comprises à la lecture de la description qui suit et à l'examen des figures qui l'accompagnent.

### BREVE DESCRIPTION DES FIGURES

Les figures sont présentées à titre indicatif et nullement limitatif de l'invention.
La [Fig. 1] montre un ordinogramme d'un procédé selon un premier aspect de l'invention.
La [Fig. 2] montre un graphique illustrant un signal de calibration et la réponse d'un système électrochimique à ce signal.
La [Fig. 3] montre un graphique illustrant la densité spectrale d'un signal de calibration et la densité spectrale de la réponse d'un système à un tel signal.
Les [Fig. 4a] et [Fig. 4b] montrent la densité spectrale d'une réponse ainsi que les facteurs d'atténuation associés.
Les [Fig. 5a] et [Fig. 5b] montrent les facteurs d'atténuation d'une réponse ainsi que les facteurs correctifs associés.
Les [Fig. 6a] à [Fig. 6d] illustrent sous la forme de graphiques le principe de calcul d'un signal sonde à l'aide d'un procédé selon un premier aspect de l'invention.
La [Fig. 7] montre un ordinogramme d'un procédé selon un deuxième aspect de l'invention.
La [Fig. 8] montre un ordinogramme d'un procédé selon un troisième aspect de l'invention.
Les [Fig. 9a] à [Fig. 9c] illustrent un exemple de détection d'un défaut dans un procédé selon un troisième aspect de l'invention.
La [Fig. 10] montre un ordinogramme d'un mode de réalisation particulier d'un procédé selon un troisième aspect de l'invention.
La [Fig. 11] montre un ordinogramme d'un mode de réalisation particulier d'un procédé selon un troisième aspect de l'invention.

### DESCRIPTION DETAILLEE

Les figures sont présentées à titre indicatif et nullement limitatif de l'invention. Dans la suite, le terme densité spectrale d'un signal fera référence à la densité spectrale de puissance du signal. De même, le terme fréquence au sens de l'invention correspond à une largeur de fréquence centrée sur la fréquence considérée et dont la valeur est fixée par les paramètres de la mesure, et plus particulièrement le rapport entre la bande passante de la mesure et l'échantillonnage des fréquences choisis.

### Détermination d'un signal sonde

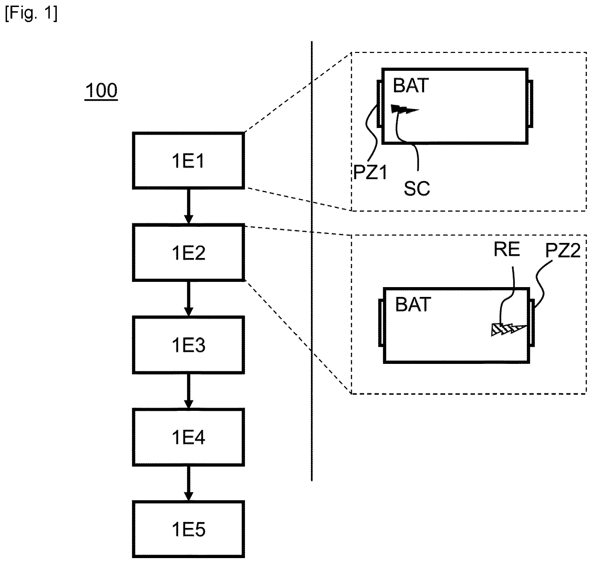

Un premier aspect de l'invention illustré en [Fig. 1] concerne un procédé 100 de détermination d'un signal sonde SS pour l'interrogation acoustique d'un système électrochimique BAT. Comme cela sera détaillé dans la suite, le procédé 100 selon un premier aspect de l'invention permet de déterminer un signal sonde SS construit pour générer une réponse RE spécifique (ou réponse RE attendue) de l'ensemble comprenant le système électrochimique BAT considéré et le transducteur générant le signal. Il permet également d'obtenir un signal sonde SS susceptible d'évoluer au cours du temps pour suivre l'évolution du système électrochimique BAT. Dans la suite, pour des raisons de concision, il sera fait référence à la réponse RE du système électrochimique BAT pour désigner la réponse RE spécifique (ou réponse RE attendue) de l'ensemble comprenant le système électrochimique BAT considéré et le transducteur générant le signal sonde SS.

Pour cela, le procédé 100 selon un premier aspect de l'invention comprend une étape 1 E1 d'émission d'un premier signal, dit signal de calibration SC, comprenant un train d'onde de multiples fréquences, la densité spectrale associée à chaque fréquence étant de préférence identique. Dans un mode de réalisation, le signal de calibration SC est généré au moyen d'un transducteur piézoélectrique PZ1 fixé sur le système électrochimique BAT. Dans un mode de réalisation, la durée du signal de calibration SC est suffisamment longue pour établir un régime stationnaire dans la réponse du système électrochimique BAT.

Dans un mode de réalisation, la densité spectrale (et donc l'amplitude) du signal de calibration SC est choisie de sorte à garantir la linéarité dans la réponse RE du système électrochimique BAT. Afin de vérifier cette condition, des signaux de calibration SC peuvent être envoyés successivement avec des amplitudes différentes, par exemple en ajustant la tension du signal envoyé à un transducteur piézoélectrique PZ1. Pour l'ensemble des mesures, l'énergie du signal transmis (c'est-à-dire de la réponse RE du système électrochimique BAT) doit être proportionnelle à l'énergie du signal de calibration SC émis.

Dans un mode de réalisation, le signal de calibration SC est défini par la gamme de fréquence qui sera considérée (fréquence minimale et maximale), l'échantillonnage en fréquence (quelles sont les fréquences précises qui composeront le signal incident), la densité spectrale associée à chaque fréquence ainsi que le nombre de périodes successives nécessaires à chaque fréquence pour atteindre un régime stationnaire.

Le procédé 100 selon un premier aspect de l'invention comprend ensuite une étape 1E2 de réception de la réponse RE du système électrochimique BAT au signal de calibration SC. La réception peut se faire au moyen d'un transducteur PZ2 (par ex. un transducteur piézoélectrique) fixé au système électrochimique BAT.

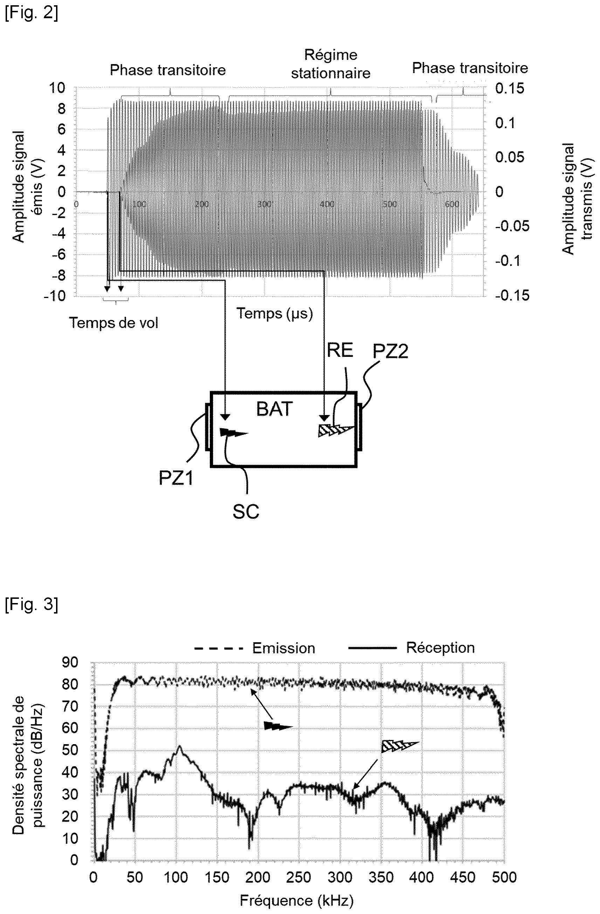

Les signaux mesurés durant les étapes 1 E1,1E2 d'émission et de réception sont illustré à la [Fig. 2] sur laquelle figure le signal de calibration SC ainsi que la réponse RE du système électrochimique BAT. Il est possible d'identifier sur cette figure les deux régimes transitoires relatifs au début et à la fin du signal de calibration SC ainsi que le régime stationnaire dans la réponse du système électrochimique BAT. L'obtention d'un régime stationnaire dans la réponse RE du système électrochimique BAT est préférable pour la détermination du signal sonde SS, et les calculs nécessaires à l'obtention du signal sonde SS décrits dans la suite sont donc préférentiellement opérés à partir des données acquises durant le régime stationnaire.

Comme illustré à la [Fig. 3], il est possible d'analyser les étapes 1E1,1E2 d'émission et de réception d'un point de vue fréquentiel en s'intéressant à la densité spectrale du signal de calibration SC (« émission ») et de la réponse du système électrochimique BAT (« réception ») en fonction de la fréquence. Dans l'exemple illustré en [Fig. 3], la densité spectrale du signal reçu (c'est-à-dire de la réponse RE du système électrochimique BAT) varie fortement sur la plage de fréquences mesurée, alors que la densité spectrale du signal de calibration SC est constante sur une grande partie de la bande de fréquences considérée.

La bande de fréquence considérée est en général choisie à partir de mesures préalables sur des systèmes BAT identiques et/ou en fonction de la nature et des caractéristiques des transducteurs PZ1, PZ2 utilisés pour générer le signal de calibration SC (ou le signal sonde SS) et/ou pour mesurer la réponse RE du système électrochimique BAT.

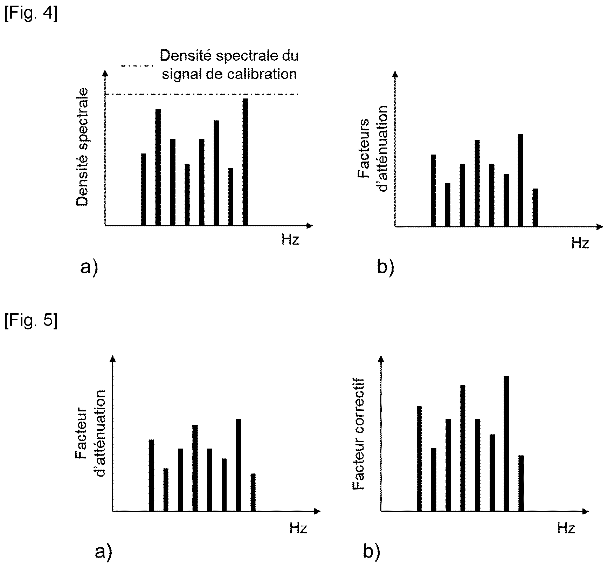

A partir de ces informations, il est possible de s'intéresser à l'atténuation du signal reçu, c'est-à-dire de la réponse RE du système électrochimique BAT, par comparaison avec le signal émis, c'est-à-dire le signal de calibration SC. Pour cela, le procédé selon l'invention comprend également une étape 1E3 de détermination, à partir de la réponse RE réceptionnée et pour chaque fréquence du signal de calibration SC, d'un facteur d'atténuation du signal. L'atténuation pour une fréquence donnée peut être définie comme la densité spectrale du signal reçue (c'est-à-dire de la réponse RE du système) à la fréquence donnée divisée par la densité spectrale du signal émis (c'est-à-dire du signal de calibration SC) à la fréquence donnée. Plus l'atténuation est grande, moins la densité spectrale de la réponse RE du système électrochimique BAT est élevée pour une densité spectrale donnée du signal de calibration SC à la même fréquence. Cette étape est illustrée aux [Fig. 4a] et [Fig. 4b]. La [Fig. 4a] représente de manière schématique la densité spectrale de la réponse RE du système électrochimique BAT au signal de calibration SC. Comme le montre le trait pointillé sur cette figure, le signal de calibration SC se caractérise par une densité spectrale sensiblement constante sur la bande de fréquences considérée. La [Fig. 4b] représente de manière schématique le facteur d'atténuation associé à chaque fréquence : plus la densité spectrale d'une fréquence considérée s'éloigne de la ligne pointillée, plus son facteur d'atténuation est élevé.

Il est ensuite possible, à partir de ces facteurs d'atténuation, de déterminer des facteurs correctifs qui seront ensuite appliqués au signal de calibration SC pour obtenir le signal sonde SS. Pour cela, le procédé 100 selon un premier aspect de l'invention comprend une étape 1E4 de détermination, pour chaque facteur d'atténuation, d'un facteur correctif fonction dudit facteur d'atténuation de sorte à associer un facteur correctif à chaque fréquence du signal de calibration SC. Cette étape est illustrée à la [Fig. 5a] et à la [Fig. 5b]. Comme on peut le voir sur ces deux figures, un facteur d'atténuation élevé (relativement aux autres) sera associé à un facteur correctif élevé (relativement aux autres). Cette relation se comprend dans la mesure où le facteur correctif cherche à compenser les effets de l'atténuation.

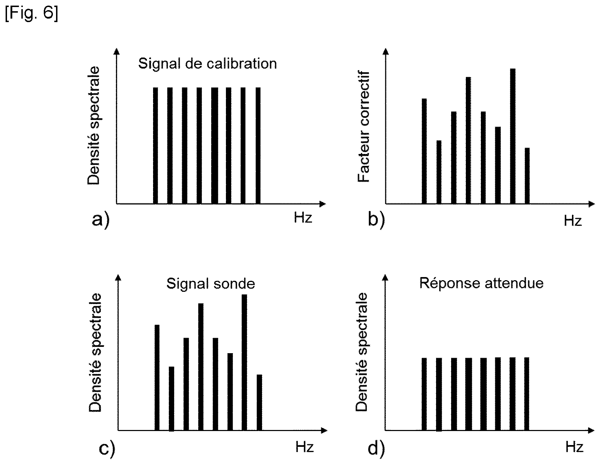

Comme mentionné précédemment, les facteurs correctifs sont ensuite utilisés pour déterminer le signal sonde SS à partir du signal de calibration SC ayant permis de déterminer ces facteurs correctifs. Pour cela, le procédé selon un premier aspect de l'invention comprend une étape 1E5 de détermination du signal sonde SS, ledit signal sonde SS étant obtenu en multipliant la densité spectrale associée à chaque fréquence du signal de calibration SC par le facteur correctif correspondant à la fréquence considérée. La [Fig. 6] montre en [Fig. 6a] une représentation schématique de la densité spectrale d'un signal de calibration SC et en [Fig. 6b] les facteurs correctifs déterminés à l'étape précédente permettant d'obtenir une réponse RE telle qu'illustrée à la [Fig. 6d], c'est-à-dire une réponse RE présentant une densité spectrale de puissance sensiblement constante. La densité spectrale du signal sonde SS illustré à la [Fig. 6c] permettant d'obtenir cette réponse RE est obtenu en multipliant la densité spectrale du signal de calibration SC associée à chaque fréquence par le facteur correctif correspondant.

Dans un mode de réalisation, le facteur correctif associé à chaque fréquence (comme illustré dans la [Fig. 6b] déjà introduite) est choisi de sorte que la densité spectrale associée à chaque fréquence dans la réponse RE du système électrochimique BAT à l'émission du signal sonde SS est sensiblement identique pour chaque fréquence (comme illustré dans [Fig. 6d] déjà introduite). Le fait de disposer d'une réponse RE au signal sonde SS dont la densité spectrale est sensiblement constante sur toute la plage de fréquence permet d'identifier très aisément et avec une grande précision les variations observées lors du fonctionnement du système électrochimique BAT. Il est alors possible de quantifier la variation de l'énergie du signal transmis par rapport à la valeur de référence et d'identifier les fréquences pour lesquelles les variations relatives sont les plus importantes. Cette facilité de comparaison est encore accrue lorsque le signal sonde SS est obtenu pour un état de référence et que la comparaison se fait entre deux mesures effectuées pour ce même état de référence. Dans un mode de réalisation alternatif, le facteur correctif associé à chaque fréquence est choisi de sorte que la densité spectrale associée à chaque fréquence dans la réponse RE du système électrochimique BAT à l'émission du signal sonde SS est croissante ou décroissante avec la fréquence. Dans un mode de réalisation alternatif, le facteur correctif associé à chaque fréquence est choisi de sorte que la densité spectrale associée à chaque fréquence dans la réponse RE du système électrochimique BAT à l'émission du signal sonde SS est une fonction parabolique de la fréquence.

Dans un mode de réalisation, les fréquences associées à un facteur d'atténuation supérieur à un seuil prédéterminé ne sont pas prises en compte. Par exemple, seules les fréquences de la réponse RE du système électrochimique BAT ayant une densité spectrale de puissance supérieure à 30 dB/Hz sont retenues.

Il peut être avantageux de déterminer le signal sonde SS pour un état du système électrochimique BAT bien défini, dit état de référence. Comme on le verra par la suite, un tel état de référence peut présenter des avantages dans le suivi de l'évolution dans le temps du système électrochimique BAT. Pour cela, dans un mode de réalisation, lors de l'étape 1E1 d'émission d'un premier signal, le signal de calibration SC est émis alors que le système électrochimique BAT se trouve dans un état de référence. Par exemple, lorsque le système électrochimique BAT est une batterie, l'état de référence pourra correspondre à un état de charge donnée. Dans un mode de réalisation, cet état de référence pourra être associé à plusieurs conditions de fonctionnement du système électrochimique BAT. Par exemple, lorsque le système électrochimique BAT est une batterie, l'état de référence pourra correspondre à un état de charge donné et à une température de la batterie donnée, ou bien encore à un état de charge donné, à une température de la batterie donnée et à un courant fournie donné.

### Contrôle qualité d'un système électrochimique

A partir d'un signal sonde SS déterminé à l'aide d'un procédé 100 selon un premier aspect de l'invention, il est ensuite possible de caractériser l'état d'un système électrochimique BAT. Une première application possible est le contrôle qualité d'un système électrochimique BAT sur une ligne de production. Cette ligne de production produit des systèmes électrochimiques BAT qu'il convient ensuite de tester à la sortie de la chaine de production. Pour cela, chaque système électrochimique BAT en sortie de production est comparé à une statistique des réponses RE établie sur une pluralité de système électrochimique BAT d'étalonnage, cette statistique étant obtenue à l'aide d'un signal sonde SS déterminé à partir d'un système électrochimique BAT de référence correspondant au produit souhaité. Cette comparaison, ou contrôle qualité, peut donc être faite en tirant bénéfice du signal sonde SS tel que déterminé par un procédé 100 selon un premier aspect de l'invention.

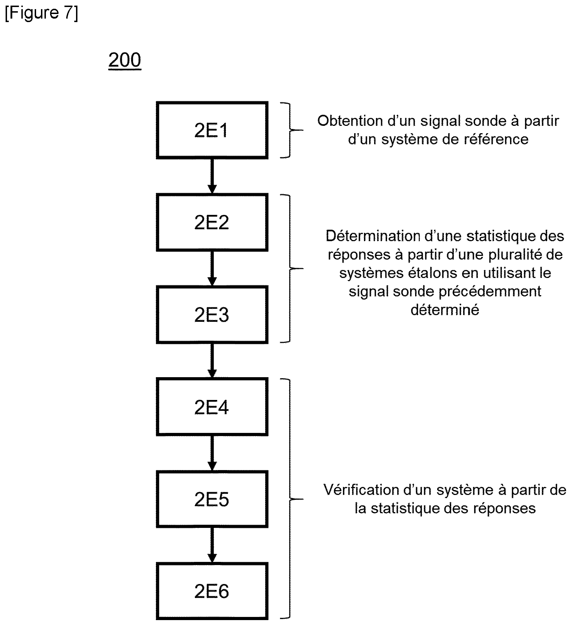

Pour cela, un deuxième aspect de l'invention illustré à la [Fig. 7] concerne un procédé 200 de vérification de la conformité d'un système électrochimique BAT à vérifier par rapport à un système électrochimique BAT de référence.

Le procédé 200 selon un deuxième aspect de l'invention comprend une étape 2E1 de détermination d'un signal sonde SS à l'aide d'un procédé 100 selon un premier aspect de l'invention, ledit procédé 100 étant mis en oeuvre sur un système électrochimique de référence BAT. Cette étape permet d'obtenir un signal sonde SS correspondant à la qualité ciblée sur la ligne de production.

Une fois le signal sonde SS déterminé, il est nécessaire d'établir une statistique des réponses RE à ce signal sonde SS. Pour cela, le procédé 200 selon un deuxième aspect de l'invention comprend, pour chaque système électrochimique BAT d'étalonnage d'une pluralité de systèmes électrochimiques BAT d'étalonnage, une étape 2E2 d'émission du signal sonde SS précédemment déterminé ; et une étape 2E3 de réception de la réponse RE du système électrochimique BAT d'étalonnage audit signal sonde SS. Ainsi, une statistique des réponses RE au signal sonde SS est constituée, cette statistique pouvant ensuite être utilisée pour vérifier les systèmes électrochimiques BAT sortant de la chaine de production.

A cette fin, le procédé 200 selon un deuxième aspect de l'invention comprend une étape 2E4 d'émission du signal sonde SS dans un système électrochimique BAT à vérifier ; une étape 2E5 de réception de la réponse RE du système électrochimique BAT à vérifier audit signal sonde SS ; et une étape 2E6 de comparaison de la réponse RE du système électrochimique BAT à vérifier à la statistique des réponses des systèmes électrochimiques BAT d'étalonnage de sorte à détecter un éventuel défaut du système électrochimique BAT à vérifier.

Dans un mode de réalisation, les systèmes électrochimiques BAT impliqués dans le procédé 200 selon un deuxième aspect de l'invention sont dans un même état de référence lorsque le signal sonde SS est déterminé où lorsqu'ils sont soumis au signal sonde SS ainsi déterminé.

### Surveillance d'un système électrochimique BAT au cours de son fonctionnement

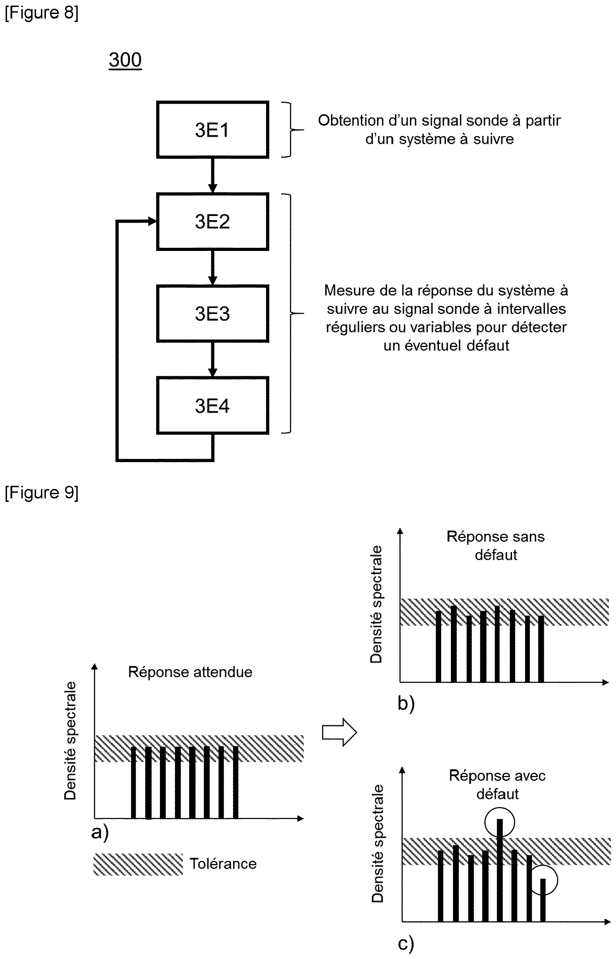

Le signal sonde SS déterminé avec un procédé 100 selon un premier aspect de l'invention peut également être utilisé pour effectuer un suivi d'un système électrochimique BAT au cours de son fonctionnement. Pour cela, un troisième aspect de l'invention illustré à la [Fig. 8] concerne un procédé 300 de détection d'un défaut d'un système électrochimique BAT.

Le procédé 300 selon un troisième aspect de l'invention comprend une étape 3E1 de détermination d'un signal sonde SS à l'aide d'un procédé 100 selon un premier aspect de l'invention. Autrement dit, un procédé 100 selon un premier aspect de l'invention est mis en oeuvre sur le système électrochimique BAT dont on souhaite assurer le suivi.

Le procédé 300 selon un troisième aspect de l'invention comprend ensuite une étape 3E2 d'émission du signal sonde SS de sorte à obtenir une réponse acoustique du système électrochimique BAT.

Le procédé 300 selon un troisième aspect de l'invention comprend ensuite une étape 3E3 de réception de la réponse du système électrochimique BAT audit signal sonde SS. Il est intéressant de noter ici que la réponse attendue est connue puisqu'un signal sonde SS a été obtenu à l'aide d'un procédé 100 selon un premier aspect de l'invention. Il devient donc très simple de vérifier que la réponse obtenue lors de cette étape est conforme à la réponse attendue.

Pour cela, le procédé selon un troisième aspect de l'invention comprend ensuite une étape 3E4 d'analyse de la réponse de sorte à détecter un éventuel défaut du système électrochimique.

De préférence, afin d'assurer un suivi au cours du fonctionnement du système électrochimique BAT, les étapes 3E2, 3E3, 3E4 d'émission d'un signal sonde SS, de réception de la réponse du système électrochimique BAT et d'analyse de la réponse sont répétées à intervalles de temps réguliers ou à intervalles de temps variables.

Dans un mode de réalisation, l'intervalle de temps entre deux mises en oeuvre de ces étapes est variable, le pas de temps associé à un système électrochimique BAT utilisé (courant important, température élevée, etc.) étant plus petit que le pas de temps associé à un système électrochimique BAT inutilisé (courant nul, etc.).

Comme cela sera détaillé dans la suite, l'analyse de la réponse RE du système électrochimique BAT au signal sonde SS peut être effectuée de plusieurs manières. Elle peut par exemple consister en une comparaison, fréquence par fréquence, de la réponse attendue et de la réponse mesurée lors de l'étape 3E3 de réception de la réponse du système électrochimique BAT. Un tel exemple de détection d'un défaut à partir d'une mesure de la réponse RE du système est illustré à la [Fig. 9]. La [Fig. 9a] illustre la réponse RE attendue au signal sonde SS ainsi qu'une tolérance qui définit l'écart par rapport à la réponse RE attendue qui peut être considéré comme normal. La [Fig. 9b] illustre une réponse RE correspondant à un état sans défaut et la [Fig. 9c] illustre une réponse RE correspondant à un état avec défaut, les parties de la réponse RE déclenchant le défaut étant cerclées de noir. La [Fig. 9] montre ainsi comment l'utilisation d'un signal sonde SS associé à une réponse RE attendue du système électrochimique BAT facilite la détermination d'une tolérance.

De manière alternative ou complémentaire, cette analyse peut comprendre le calcul d'une convolution entre la densité spectrale de la réponse RE attendue et la densité spectrale de la réponse RE obtenue. Plus généralement, toute méthode de comparaison de deux signaux peut être mise en oeuvre, un écart trop important entre la réponse RE attendue et la réponse RE obtenue témoignant d'un défaut au sein du système électrochimique BAT. Comme cela sera illustré dans la suite, la comparaison peut également se faire à partir d'une statistique des réponses au signal sonde SS du système électrochimique BAT.

Il peut être avantageux de mettre en oeuvre le procédé 300 selon un troisième aspect de l'invention à l'aide d'un signal sonde SS déterminé pour un état de référence du système électrochimique BAT dont on souhaite assurer le suivi. En effet, comme cela a déjà été détaillé, l'utilisation d'un état de référence présente certains avantages en matière de facilité de détection d'un éventuel défaut. Pour cela, dans un mode de réalisation, lors de l'étape 3E1 de détermination d'un signal sonde SS, le signal sonde SS est déterminé alors que le système électrochimique BAT est dans un état de référence. De préférence, cet état de référence est défini par rapport à l'application qui est faite du système électrochimique BAT et/ou au profil de mission du système électrochimique BAT. Il peut par exemple être choisi à l'état de charge maximal, courant nul et une plage de température définie mais aussi à un état de charge partiel, un courant et une plage de température définis.

Il est utile de noter que le choix d'un état de référence pour la détermination du signal sonde SS n'impose pas d'effectuer les étapes 3E2, 3E3, 3E4 d'émission d'un signal sonde SS, de réception de la réponse du système électrochimique BAT et d'analyse de la réponse lorsque le système électrochimique BAT est dans cet état de référence. Ces étapes peuvent au contraire être également mises en oeuvre durant le fonctionnement, entre deux instants où le système électrochimique BAT est dans cet état de référence. Lors d'une telle mise en oeuvre, les variations d'énergie transmise par le signal sonde SS et les variations de la densité spectrale de puissance observées dans la réponse RE du système électrochimique BAT par rapport à la réponse RE attendue évoluent de manière réversible et suivent, sauf dysfonctionnement, une évolution semblable à chaque cycle pour se rapprocher de la valeur de référence lorsque le système électrochimique BAT s'approche à nouveau de l'état de référence (si l'on exclue le vieillissement qui induit une légère dérive comme cela sera illustré dans la suite). L'utilisation d'un état de référence permet donc de vérifier que cette évolution réversible de la réponse au signal sonde SS se produit.

De la même alternative, il est possible de vérifier l'état du système électrochimique BAT seulement lorsque ce dernier est dans l'état de référence. Certes, l'évolution décrite plus haut n'est plus observable, mais ce mode de mise en oeuvre peut être adapté aux situations où l'on veut réduire le nombre de mises en oeuvre des étapes 3E2, 3E3, 3E4 d'émission d'un signal sonde SS, de réception de la réponse du système électrochimique BAT et d'analyse de la réponse ou bien encore dans les situations où l'évolution de la réponse en dehors de l'état de référence présente peu d'intérêt. Pour cela, dans un mode de réalisation, les étapes 3E2, 3E3, 3E4 d'émission d'un signal sonde SS, de réception de la réponse du système électrochimique BAT et d'analyse de la réponse sont mises en oeuvre à chaque fois que le système électrochimique BAT est dans l'état de référence utilisé pour déterminer le signal sonde SS. La comparaison de la réponse mesurée par rapport à la réponse attendue est facilitée, le système électrochimique BAT étant dans un état de référence à chaque étape de mesure de la réponse RE.

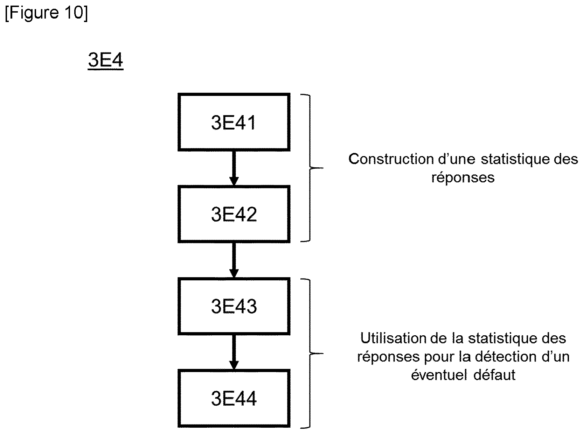

Comme déjà évoquée plus haut, il peut être intéressant de procéder à une analyse statistique de la réponse RE du système électrochimique BAT au signal sonde SS. Cette approche permet notamment d'automatiser la détermination du ou des seuils ou de la tolérance correspondant à un dysfonctionnement du système électrochimique BAT. Elle permet également d'automatiser la mise à jour de ces seuils par l'ajout de mesures venant alimenter la statistique des réponses RE au cours du fonctionnement du système électrochimique BAT. Pour cela, dans un mode de réalisation illustré à la [Fig. 10], l'étape 3E4 d'analyse de la réponse comprend :
- une sous-étape 3E41 de détermination de la densité spectrale de la réponse RE au signal sonde SS ;
- une sous-étape 3E42 de mémorisation de la densité spectrale de la réponse RE au signal sonde SS ;
- une sous-étape 3E43 de comparaison de la densité spectrale déterminée à une statistique des réponses RE, ladite statistique étant déterminée à partir des densités spectrales mémorisées lors de mises en oeuvre précédentes de l'étape 3E42 de mémorisation de la densité spectrale de la réponse RE au signal sonde SS ;
- une sous-étape 3E44 de détection d'un défaut du système électrochimique BAT lorsque l'écart entre la densité spectrale déterminée lors de la sous-étape 3E41 de détermination et la statistique des réponses est supérieur à une valeur prédéterminée.

Dans un mode de réalisation, un défaut du système électrochimique BAT est détecté lors de la sous-étape 3E44 de détection d'un défaut du système électrochimique lorsque la densité spectrale de la réponse RE s'écarte de plus de 3σ par rapport à la statistique des réponses pour au moins une fréquence.

Dans un mode de réalisation alternatif, un défaut du système électrochimique BAT est détecté lors de la sous-étape 3E44 de détection d'un défaut du système électrochimique lorsque la densité spectrale de la réponse RE s'écarte de plus de 3σ par rapport à la statistique des réponses pour une pluralité de fréquences, le nombre de fréquence constituant la pluralité de fréquences étant choisi en fonction de la sensibilité désirée. Il peut être utile de noter que cette méthode statistique peut également être utilisé dans le cadre du procédé 200 de de vérification de la conformité d'un système électrochimique BAT selon un deuxième aspect de l'invention, la statistique utilisée étant alors celle obtenue à partir de la pluralité de système électrochimique BAT d'étalonnage.

Les variations de la réponses RE au cours du temps permettent de déterminer si les matériaux qui composent le système électrochimique BAT subissent des variations réversibles (évolutions répétables d'un cycle de charge - décharge sur l'autre, influence de la température) comprises dans des limites prédéfinies ou une dérive lente et continue (vieillissement de l'ensemble batterie et instrumentation), voire une variation brutale, dépassant les limites prédéfinies, qui serait le signe d'un dysfonctionnement. Il peut donc être intéressant de s'intéresser à ces variations.

Pour cela, dans un mode de réalisation, la vitesse de la variation de la réponse RE du système électrochimique BAT au signal sonde SS est également prise en compte. Plus particulièrement, lorsque la vitesse de la variation de la réponse (définie comme la différence entre les deux dernières réponses RE mesurées divisée par le temps séparant ces deux mesures) s'écarte au-delà d'un seuil prédéfini, un dysfonctionnement du système électrochimique BAT est détecté lors de l'étape 3E4 d'analyse de la réponse. Le seuil prédéfini peut être fixé en fonction de vitesses de la variation considérées comme normales et/ou d'une statistique des vitesses de la variation constituée en même temps que la statistique des réponses. De préférence, la vérification de cette variation se fera par fréquence. Autrement dit, la variation de la densité spectrale sera évaluée pour chaque fréquence de sorte à obtenir autant de valeurs de variation que de fréquences considérées. Dans ce cas, un dysfonctionnement pourra être constaté si une fréquence au moins est associée à une variation supérieure à un seuil prédéterminé ou bien alors lorsqu'un nombre prédéfini de fréquences sont associées à une variation supérieure à un seuil prédéfini. Dans le deuxième cas, le nombre de fréquences considéré pourra dépendre de la sensibilité souhaitée dans la détection d'un dysfonctionnent. Le seuil pourra varier en fonction de la fréquence considérée ou être identique pour toutes les fréquences.

Dans un mode de réalisation, lorsqu'un défaut est détecté, le procédé selon un troisième aspect de l'invention comprend une étape d'envoi d'un signal au système de gestion en charge du système électrochimique de sorte que ce dernier puisse appliquer des mesures correctives.

### Suivi du vieillissement du système électrochimique

Il peut être intéressant d'utiliser le signal sonde SS non seulement pour identifier un défaut, mais également pour faire un suivi du vieillissement d'un système électrochimique BAT. En effet, si le signal sonde SS est déterminé pour un même système BAT pour un état de référence donné et pour deux instants séparés dans le temps, les facteurs de correction associés au signal sonde SS déterminés au premier instant seront différent des facteurs de correction associés au signal sonde SS déterminés au deuxième instant pour une réponse RE attendue donnée. Cette évolution dans les facteurs de correction traduit une évolution du système électrochimique BAT dans le temps, généralement induit par le vieillissement.

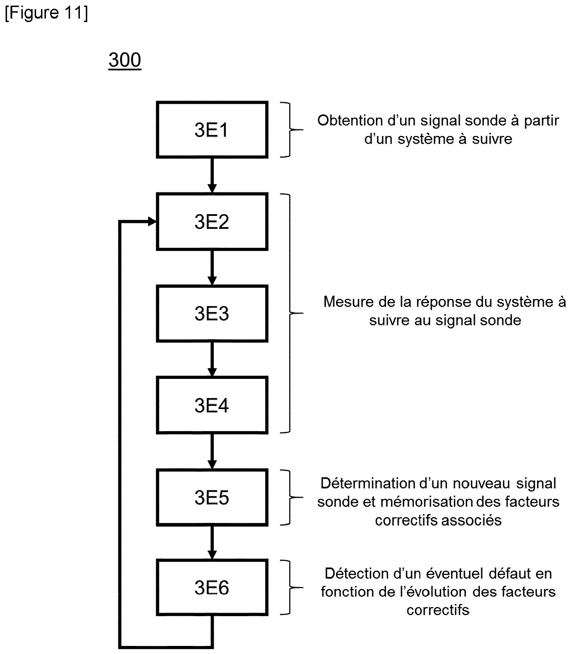

Afin de tirer parti de cela, dans un mode de réalisation illustré à la [Fig. 11], le procédé 300 selon un troisième aspect de l'invention comprend, après l'étape 3E4 d'analyse de la réponse de sorte à détecter un défaut du système électrochimique, une étape 3E5 de détermination d'un nouveau signal sonde SS à l'aide d'un procédé 100 selon un premier aspect de l'invention, les facteurs correctifs étant mémorisés. De plus, dans ce mode de réalisation, le procédé 300 selon un troisième aspect de l'invention comprend également une étape 3E6 d'analyse de l'évolution des facteurs correctifs de sorte à détecter un éventuel défaut. Dans un mode de réalisation, l'étape 3E5 de détermination d'un nouveau signal sonde SS n'est mise en oeuvre que lorsque le système électrochimique BAT est dans l'état de référence. Dans un mode de réalisation, un indicateur de vieillissement du système électrochimique (et/ou des moyens de génération et/ou d'acquisition des signaux) est déterminé à partir de l'évolution des facteurs correctifs.

Plus généralement, l'évolution des facteurs correctifs peut être utilisée pour caractériser un grand nombre de phénomènes. Il est par exemple possible de s'intéresser à la vitesse d'évolution de ces facteurs correctifs (vitesse moyenne sur l'ensemble des fréquences du signal, vitesse maximale et/ou vitesse du ou des facteurs correctifs associés à une ou plusieurs fréquences particulières) afin de déterminer la vitesse des mécanismes de dégradation des matériaux et, par extension, le vieillissement du système électrochimique BAT.

Il est également possible de s'intéresser à l'accélération de l'évolution de ces facteurs correctifs. Par exemple, une accélération ponctuelle de la vitesse d'évolution de ces facteurs correctifs pourra être attribuée à une dégradation des matériaux liée à de fortes sollicitations temporaires du système électrochimique BAT (par exemple un fonctionnement à forte puissance en charge rapide ou en décharge, un fonctionnement à température élevée ou une charge à basse température, etc.).

De manière générale, l'analyse approfondie de la vitesse d'évolution des facteurs correctifs permet d'identifier les conditions optimales de fonctionnement du système électrochimique BAT et celles qui doivent être évitées, pour définir de manière objective le domaine de fonctionnement optimal du système électrochimique BAT (gammes de d'état de charge, de température et de puissance maximale). A noter que le domaine de fonctionnement optimal du système électrochimique BAT n'a aucune raison d'être constant sur toute la vie du système électrochimique BAT : par exemple certaines conditions de fonctionnement apportant de fortes sollicitations peuvent être acceptées sans trop de problème sur des batteries neuves mais ne le seront plus sur des batteries en fin de vie.

### Dispositif mettant en oeuvre l'invention

Un quatrième aspect de l'invention concerne un dispositif comprenant les moyens configurés pour mettre en oeuvre un procédé selon un premier, un deuxième ou un troisième aspect de l'invention. Dans un mode de réalisation, le dispositif comprend des moyens PZ1 pour générer un signal de calibration SC ou un signal sonde SS au sein d'un système électrochimique BAT. Dans un mode de réalisation, ces moyens de génération peuvent être disposés de manière amovible sur le système électrochimique. Dans un mode de réalisation, le dispositif comprend des moyens PZ2 pour réceptionner la réponse RE du système électrochimique au signal de calibration SC ou un signal sonde SS. Dans un mode de réalisation, ces moyens de réception peuvent être disposés de manière amovible sur le système électrochimique. Dans un mode de réalisation, le dispositif comprend un moyen de calcul et une mémoire, la mémoire étant configurée pour stocker les instructions nécessaires pour la mise en oeuvre d'un procédé selon un premier, un deuxième ou un troisième aspect de l'invention. Par ailleurs, le moyen de calcul est configuré pour accéder à cette mémoire est exécuter les instructions. Le moyen de calcul est configuré pour commander les moyens PZ1 de génération du signal sonde SS ou du signal de calibration SC et pour réceptionner les données collectées par le moyen de réception PZ2 de la réponse RE du système électrochimique BAT. Dans un mode de réalisation, le dispositif est un système de gestion de système électrochimique BAT, par exemple un système de gestion d'une batterie.

## Revendications

1. Procédé (100) de détermination d'un signal sonde (SS) pour l'interrogation acoustique d'un système électrochimique (BAT), ledit procédé étant **caractérisé en ce qu'**il comprend :
- une étape (1E1) d'émission d'un premier signal, dit signal de calibration (SC), comprenant un train d'onde de multiples fréquences, la densité spectrale associée à chaque fréquence étant identique, de sorte à induire un réponse (RE) du système électrochimique (BAT) ;
- une étape (1E2) de réception de la réponse (RE) du système électrochimique (BAT) au signal de calibration (SC) ;
- une étape (1E3) de détermination, à partir de la réponse (RE) réceptionnée et pour chaque fréquence du signal de calibration (SC), d'un facteur d'atténuation du signal ;
- une étape (1E4) de détermination, pour chaque facteur d'atténuation, d'un facteur correctif fonction dudit facteur d'atténuation de sorte à associer un facteur correctif à chaque fréquence du signal de calibration (SC) ;
- une étape (1E5) de détermination du signal sonde (SS), ledit signal sonde (SS) étant obtenu en multipliant la densité spectrale associée à chaque fréquence du signal de calibration (SC) par le facteur correctif correspondant à la fréquence considérée.

2. Procédé (100) selon la revendication précédente **caractérisé en ce que** la densité spectrale associée à chaque fréquence dans le signal de calibration (SC) est choisie de sorte à induire une réponse linéaire du système électrochimique (BAT).

3. Procédé (100) selon l'une des revendications précédentes **caractérisé en ce que** la durée du signal sonde (SS) est suffisamment longue pour établir un régime stationnaire dans la réponse (RE) du système électrochimique (BAT).

4. Procédé (100) selon l'une des revendications précédentes **caractérisé en ce que**, les fréquences associées à un facteur d'atténuation supérieure à un seuil prédéterminé ne sont pas prises en compte pour la détermination du signal sonde (SS).

5. Procédé (100) selon l'une des revendications précédentes **caractérisé en ce que**, lors de l'étape (1E1) d'émission d'un premier signal, le signal de calibration (SC) est émis alors que le système électrochimique (BAT) se trouve dans un état de référence.

6. Procédé (200) de vérification de la conformité d'un système électrochimique (BAT) à vérifier par rapport à un système électrochimique de référence (BAT) **caractérisé en ce qu'**il comprend :
- une étape (2E1) de détermination d'un signal sonde (SS) à l'aide d'un procédé selon l'une des revendications 1 à 5 mis en oeuvre sur un système électrochimique de référence ;
pour chaque système électrochimique d'étalonnage (BAT) d'une pluralité de systèmes électrochimiques d'étalonnage (BAT) :
- une étape (2E2) d'émission du signal sonde (SS) précédemment déterminé ;
- une étape (2E3) de réception de la réponse (RE) du système électrochimique d'étalonnage (BAT) audit signal sonde (SS) ;
une statistique des réponses (RE) des systèmes d'étalonnage étant ainsi obtenue ; le procédé comprenant également :
- une étape (2E4) d'émission du signal sonde (SS) dans un système électrochimique (BAT) à vérifier ;
- une étape (2E5) de réception de la réponse (RE) du système électrochimique (BAT) à vérifier audit signal sonde (SS) ;
- une étape (2E6) de comparaison de la réponse du système électrochimique (BAT) à vérifier à la statistique des réponses des systèmes électrochimique (BAT) d'étalonnage de sorte à détecter un défaut du système électrochimique (BAT) à vérifier.

7. Procédé (300) de détection d'un défaut d'un système électrochimique, ledit procédé étant **caractérisé en ce qu'**il comprend :
- une étape (3E1) de détermination d'un signal sonde à l'aide d'un procédé selon l'une des revendications 1 à 5 ;
- une étape (3E2) d'émission du signal sonde (SS) précédemment déterminé ;
- une étape (3E3) de réception de la réponse du système électrochimique (BAT) audit signal sonde (SS) ;
- une étape (3E4) d'analyse de la réponse de sorte à détecter un défaut du système électrochimique ;
les étapes (3E2,3E3,3E4) d'émission d'un signal sonde (SS), de réception de la réponse du système électrochimique (BAT) et d'analyse de la réponse étant répétées à intervalles de temps réguliers ou à intervalles de temps variables.

8. Procédé (300) selon la revendication précédente **caractérisé en ce que** lors de l'étape (3E1) de détermination d'un signal sonde (SS), le signal sonde (SS) est déterminé alors que le système électrochimique (BAT) est dans un état de référence.

9. Procédé (300) selon la revendication précédente **caractérisé en ce que** les étapes (3E2,3E3,3E4) d'émission d'un signal sonde (SS), de réception de la réponse du système électrochimique (BAT) et d'analyse de la réponse sont mises en oeuvre à chaque fois que le système électrochimique (BAT) est dans l'état de référence utilisé pour déterminer le signal sonde (SS) lors de l'étape (3E1) de détermination d'un signal sonde (SS).

10. Procédé (300) selon l'une des trois revendications précédentes **caractérisé en ce que** l'étape (3E3) d'analyse de la réponse comprend :
- une sous-étape (3E41) de détermination de la densité spectrale de la réponse au signal sonde (SS) ;
- une sous-étape (3E42) de mémorisation de la densité spectrale de la réponse au signal sonde (SS) ;
- une sous-étape (3E43) de comparaison de la densité spectrale déterminée à une statistique des réponses (RE), ladite statistique des réponses (RE) étant déterminée à partir des densités spectrales mémorisées lors des mises en oeuvre précédentes de l'étape (3E42) de mémorisation de la densité spectrale de la réponse (RE) au signal sonde (SS) ;
- une sous-étape (3E44) de détection d'un défaut du système électrochimique lorsque l'écart entre la densité spectrale déterminée lors de la sous-étape (3E31) de détermination et la statistique des réponses est supérieur à une valeur prédéterminée.

11. Procédé (200,300) selon l'une des revendications 6 à 10 **caractérisé en ce que** le signal sonde (SS) est redéterminé à intervalle régulier ou sur demande d'un utilisateur.

12. Dispositif de détermination d'un signal sonde (SS), de vérification de la conformité d'un système électrochimique (BAT) ou de détection d'un défaut d'un système électrochimique (BAT) comprenant les moyens configurés pour mettre en oeuvre un procédé selon l'une des revendications précédentes.

13. Programme d'ordinateur comprenant des instructions qui conduisent un dispositif selon la revendication précédente à mettre en oeuvre le procédé selon l'une des revendications 1 à 11.

14. Support de données lisible par ordinateur, sur lequel est enregistré le programme d'ordinateur selon la revendication précédente.

## Patentansprüche

1. Verfahren (100) zum Bestimmen eines Sondensignals (SS) für die akustische Abfrage eines elektrochemischen Systems (BAT), wobei das Verfahren **dadurch gekennzeichnet ist, dass** es umfasst:
- einen Schritt (1E1) des Sendens eines ersten Signals, des sogenannten Kalibriersignals (SC), der einen Wellenzug mit mehreren Frequenzen umfasst, wobei die jeder Frequenz zugeordnete Spektraldichte identisch ist, so dass eine Reaktion (RE) des elektrochemischen Systems (BAT) induziert wird;
- einen Schritt (1E2) des Empfangens der Reaktion (RE) des elektrochemischen Systems (BAT) auf das Kalibriersignal (SC);
- einen Schritt (1E3) des Bestimmens eines Signaldämpfungsfaktors ausgehend von der empfangenen Reaktion (RE) und für jede Frequenz des Kalibriersignals (SC);
- einen Schritt (1E4) des Bestimmens für jeden Dämpfungsfaktor eines Korrekturfaktors, der von dem Dämpfungsfaktor abhängt, so dass jeder Frequenz des Kalibriersignals (SC) ein Korrekturfaktor zugeordnet wird;
- einen Schritt (1E5) des Bestimmens des Sondensignals (SS), wobei das Sondensignal (SS) durch Multiplikation der jeder Frequenz des Kalibriersignals (SC) zugeordneten Spektraldichte mit dem der betrachteten Frequenz entsprechenden Korrekturfaktor erhalten wird.

2. Verfahren (100) nach vorhergehendem Anspruch, **dadurch gekennzeichnet, dass** die jeder Frequenz im Kalibriersignal (SC) zugeordnete Spektraldichte so gewählt wird, dass eine lineare Reaktion des elektrochemischen Systems (BAT) induziert wird.

3. Verfahren (100) nach einem der vorhergehenden Ansprüche, **dadurch gekennzeichnet, dass** die Dauer des Sondensignals (SS) lang genug ist, um einen stationären Zustand in der Reaktion (RE) des elektrochemischen Systems (BAT) herzustellen.

4. Verfahren (100) nach einem der vorhergehenden Ansprüche, **dadurch gekennzeichnet, dass** die Frequenzen, die einem Dämpfungsfaktor zugeordnet sind, der größer als ein vorbestimmter Schwellenwert ist, bei der Bestimmung des Sondensignals (SS) nicht berücksichtigt werden.

5. Verfahren (100) nach einem der vorhergehenden Ansprüche, **dadurch gekennzeichnet, dass** in dem Schritt (1E1) des Sendens eines ersten Signals das Kalibriersignal (SC) gesendet wird, während sich das elektrochemische System (BAT) in einem Referenzzustand befindet.

6. Verfahren (200) zur Überprüfung der Konformität eines zu überprüfenden elektrochemischen Systems (BAT) mit einem elektrochemischen Referenzsystem (BAT), **dadurch gekennzeichnet, dass** es umfasst:
- einen Schritt (2E1) des Bestimmens eines Sondensignals (SS) mithilfe eines Verfahrens nach einem der Ansprüche 1 bis 5, das in einem elektrochemischen Referenzsystem angewendet wird;
für jedes elektrochemische Kalibriersystem (BAT) aus einer Vielzahl von elektrochemischen Kalibriersystemen (BAT):
- einen Schritt (2E2) des Sendens des zuvor bestimmten Sondensignals (SS);
- einen Schritt (2E3) des Empfangens der Reaktion (RE) des elektrochemischen Kalibriersystems (BAT) auf das Sondensignal (SS);
wobei eine Statistik der Reaktionen (RE) der Kalibriersysteme erhalten wird; wobei das Verfahren auch Folgendes umfasst:
- einen Schritt (2E4) des Sendens des Sondensignals (SS) in einem zu prüfenden elektrochemischen System (BAT);
- einen Schritt (2E5) des Empfangens der Reaktion (RE) des zu überprüfenden elektrochemischen Systems (BAT) auf das Sondensignal (SS);
- einen Schritt (2E6) des Vergleichens der Reaktion des zu überprüfenden elektrochemischen Systems (BAT) mit der Statistik der Reaktionen der elektrochemischen Kalibriersysteme (BAT), um so einen Fehler des zu überprüfenden elektrochemischen Systems (BAT) zu erkennen.

7. Verfahren (300) zum Erkennen eines Fehlers eines elektrochemischen Systems, wobei das Verfahren **dadurch gekennzeichnet ist, dass** es umfasst:
- einen Schritt (3E1) des Bestimmens eines Sondensignals unter Verwendung eines Verfahrens nach einem der Ansprüche 1 bis 5;
- einen Schritt (3E2) des Sendens des zuvor bestimmten Sondensignals (SS);
- einen Schritt (3E3) des Empfangens der Reaktion des elektrochemischen Systems (BAT) auf das Sondensignal (SS);
- einen Schritt (3E4) der Analyse der Reaktion, um einen Fehler des elektrochemischen Systems zu erkennen;
wobei die Schritte (3E2, 3E3, 3E4) des Sendens eines Sondensignals (SS), des Empfangens der Reaktion des elektrochemischen Systems (BAT) und des Analysierens der Reaktion in regelmäßigen Zeitintervallen oder in variablen Zeitintervallen wiederholt werden.

8. Verfahren (300) nach vorhergehendem Anspruch, **dadurch gekennzeichnet, dass** in dem Schritt (3E1) des Bestimmens eines Sondensignals (SS) das Sondensignal (SS) bestimmt wird, während sich das elektrochemische System (BAT) in einem Referenzzustand befindet.

9. Verfahren (300) nach vorhergehendem Anspruch, **dadurch gekennzeichnet, dass** die Schritte (3E2, 3E3, 3E4) des Sendens eines Sondensignals (SS), des Empfangens der Reaktion des elektrochemischen Systems (BAT) und des Analysierens der Reaktion jedes Mal durchgeführt werden, wenn sich das elektrochemische System (BAT) in dem Referenzzustand befindet, der zur Bestimmung des Sondensignals (SS) im Schritt (3E1) der Bestimmung eines Sondensignals (SS) verwendet wird.

10. Verfahren (300) nach einem der drei vorhergehenden Ansprüche, **dadurch gekennzeichnet, dass** der Schritt (3E3) der Analyse der Reaktion Folgendes umfasst:
- einen Unterschritt (3E41) des Bestimmens der Spektraldichte der Reaktion auf das Sondensignal (SS);
- einen Unterschritt (3E42) des Speicherns der Spektraldichte der Reaktion auf das Sondensignal (SS);
- einen Unterschritt (3E43) des Vergleichens der ermittelten Spektraldichte mit einer Statistik der Reaktionen (RE), wobei die Statistik der Reaktionen (RE) anhand der Spektraldichten ermittelt wird, die bei den vorherigen Implementierungen des Speicherschritts (3E42) der Spektraldichte der Reaktion (RE) auf das Sondensignal (SS) gespeichert wurden;
- einen Unterschritt (3E44) zum Erkennen eines Fehlers des elektrochemischen Systems, wenn die Abweichung zwischen der im Bestimmungsunterschritt (3E31) bestimmten Spektraldichte und der Statistik der Reaktionen größer ist als ein vorbestimmter Wert.

11. Verfahren (200, 300) nach einem der Ansprüche 6 bis 10, **dadurch gekennzeichnet, dass** das Sondensignal (SS) in regelmäßigen Intervallen oder auf Anforderung eines Benutzers neu bestimmt wird.

12. Vorrichtung zur Bestimmung eines Sondensignals (SS), zur Überprüfung der Konformität eines elektrochemischen Systems (BAT) oder zur Erkennung eines Fehlers eines elektrochemischen Systems (BAT), Mittel umfassend, die so konfiguriert sind, dass sie ein Verfahren nach einem der vorhergehenden Ansprüche durchführen.

13. Computerprogramm mit Anweisungen, die eine Vorrichtung nach dem vorhergehenden Anspruch dazu veranlassen, das Verfahren nach einem der Ansprüche 1 bis 11 umzusetzen.

14. Computerlesbarer Datenträger, auf dem das Computerprogramm nach dem vorhergehenden Anspruch gespeichert ist.

## Claims

1. Method (100) for determining a probe signal (SS) for acoustically interrogating an electrochemical system (BAT), said method being **characterised in that** it comprises:
- a step (1E1) of transmitting a first signal, called the calibration signal (SC), comprising a wave train of multiple frequencies, the spectral density associated with each frequency being identical, in such a way as to induce a response (RE) of the electrochemical system (BAT);
- a step (1E2) of receiving the response (RE) of the electrochemical system (BAT) to the calibration signal (SC);
- a step (1E3) of determining, on the basis of the received response (RE) and for each frequency of the calibration signal (SC), a signal attenuation factor;
- a step (1E4) of determining, for each attenuation factor, a correction factor according to said attenuation factor so as to associate a correction factor with each frequency of the calibration signal (SC);
- a step (1E5) of determining the probe signal (SS), said probe signal (SS) being obtained by multiplying the spectral density associated with each frequency of the calibration signal (SC) by the correction factor corresponding to the frequency in question.

2. Method (100) according to the preceding claim **characterised in that** the spectral density associated with each frequency in the calibration signal (SC) is chosen in such a way as to induce a linear response of the electrochemical system (BAT).

3. Method (100) according to one of the preceding claims **characterised in that** the duration of the probe signal (SS) is sufficiently long to establish a stationary regime in the response (RE) of the electrochemical system (BAT).

4. Method (100) according to one of the preceding claims **characterised in that**, the frequencies associated with an attenuation factor greater than a predetermined threshold are not taken into account in the determining of the probe signal (SS).

5. Method (100) according to one of the preceding claims **characterised in that**, during the step (1E1) of transmitting a first signal, the calibration signal (SC) is transmitted while the electrochemical system (BAT) is in a reference state.

6. Method (200) for checking the conformity of an electrochemical system (BAT) to be checked with respect to a reference electrochemical system (BAT) **characterised in that** it comprises:
- a step (2E1) of determining a probe signal (SS) using a method according to one of claims 1 to 5 implemented on a reference electrochemical system;
for each calibration electrochemical system (BAT) of a plurality of calibration electrochemical systems (BAT):
- a step (2E2) of transmitting the probe signal (SS) determined hereinabove;
- a step (2E3) of receiving the response (RE) of the calibration electrochemical system (BAT) to said probe signal (SS);
a statistic of the responses (RE) of the calibration systems being thus obtained; the method also comprising:
- a step (2E4) of transmitting the probe signal (SS) in an electrochemical system (BAT) to be checked;
- a step (2E5) of receiving the response (RE) of the electrochemical system (BAT) to be checked to said probe signal (SS);
- a step (2E6) of comparing the response of the electrochemical system (BAT) to be checked with the statistic of responses of the calibration electrochemical systems (BAT) in such a way as to detect a fault of the electrochemical system (BAT) to be checked.

7. Method (300) for detecting a fault of an electrochemical system, said method being **characterised in that** it comprises:
- a step (3E1) of determining a probe signal using a method according to one of claims 1 to 5;
- a step (3E2) of transmitting the probe signal (SS) determined hereinabove;
- a step (3E3) of receiving the response of the electrochemical system (BAT) to said probe signal (SS);
- a step (3E4) of analysing the response in such a way as to detect a fault of the electrochemical system;
the steps (3E2, 3E3, 3E4) of transmitting a probe signal (SS), of receiving the response of the electrochemical system (BAT) and of analysing the response being repeated at regular time intervals or at variable time intervals.

8. Method (300) according to the preceding claim **characterised in that** during the step (3E1) of determining a probe signal (SS), the probe signal (SS) is determined while the electrochemical system (BAT) is in a reference state.

9. Method (300) according to the preceding claim **characterised in that** the steps (3E2, 3E3, 3E4) of transmitting a probe signal (SS), of receiving the response of the electrochemical system (BAT) and of analysing the response are implemented each time that the electrochemical system (BAT) is in the reference state used for determining the probe signal (SS) during the step (3E1) of determining a probe signal (SS).

10. Method (300) according to one of the three preceding claims **characterised in that** the step (3E3) of analysing the response comprises:
- a sub-step (3E41) of determining the spectral density of the response to the probe signal (SS);
- a sub-step (3E42) of memorising the spectral density of the response to the probe signal (SS);
- a sub-step (3E43) of comparing the determined spectral density with a statistic of the responses (RE), said statistic of responses (RE) being determined from spectral densities memorised during preceding implementations of the step (3E42) of memorising the spectral density of the response (RE) to the probe signal (SS);
- a sub-step (3E44) of detecting a fault of the electrochemical system when the difference between the spectral density determined during the sub-step (3E31) of determining and the statistic of the responses is greater than a predetermined value.

11. Method (200, 300) according to one of claims 6 to 10 **characterised in that** the probe signal (SS) is redetermined at a regular interval or on demand from a user.

12. Device for determining a probe signal (SS), for checking the conformity of an electrochemical system (BAT) or for detecting a fault of an electrochemical system (BAT) comprising means configured to implement a method according to one of the preceding claims.

13. Computer program comprising instructions that leads a device according to the preceding claim to implement the method according to one of claims 1 to 11.

14. A computer-readable storage medium on which is recorded the computer program according to the preceding claim.
